(19) Europäisches Patentamt
European Patent Office
Office européen des brevets

(11) **EP 2 676 301 B1**

(12) **FASCICULE DE BREVET EUROPEEN**

(45) Date de publication et mention
de la délivrance du brevet:
**21.11.2018 Bulletin 2018/47**

(21) Numéro de dépôt: **12706223.0**

(22) Date de dépôt: **14.02.2012**

(51) Int Cl.:
*H01L 31/08* [(2006.01)]   *H01L 31/09* [(2006.01)]
*G01J 5/20* [(2006.01)]

(86) Numéro de dépôt international:
**PCT/EP2012/052524**

(87) Numéro de publication internationale:
**WO 2012/110522 (23.08.2012 Gazette 2012/34)**

(54) **CELLULE DE DÉTECTION TÉRAHERTZ**

TERAHERTZ-DETEKTIONSZELLE

TERAHERTZ DETECTION CELL

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **14.02.2011 FR 1151195**

(43) Date de publication de la demande:
**25.12.2013 Bulletin 2013/52**

(73) Titulaire: **Centre National de la Recherche
Scientifique
(C.N.R.S.)
75794 Paris Cedex 16 (FR)**

(72) Inventeurs:
• **VASSANT, Simon**
**F-75010 Paris (FR)**
• **PARDO, Fabrice**
**F-94400 Vitry-sur-seine (FR)**
• **PELOUARD, Jean-Luc**
**F-75020 Paris (FR)**
• **GREFFET, Jean-Jacques**
**F-91370 Verrieres Le Buisson (FR)**
• **ARCHAMBAULT, Alexandre**
**F-75013 Paris (FR)**
• **MARQUIER, François**
**F-91160 Longjumeau (FR)**

(74) Mandataire: **Osha Liang
2, rue de la Paix
75002 Paris (FR)**

(56) Documents cités:
**US-A1- 2008 315 098**

• **VASSANT S ET AL: "Tailoring GaAs terahertz
radiative properties with surface phonons
polaritons", APPLIED PHYSICS LETTERS, vol.
97, no. 16, 18 octobre 2010 (2010-10-18), pages
161101-161101, XP012137316, AIP, AMERICAN
INSTITUTE OF PHYSICS, MELVILLE, NY, US
ISSN: 0003-6951, DOI: 10.1063/1.3497645**
• **MARQUIER F ET AL: "Resonant emission and
transmission of infrared radiation by
microstructured surfaces supporting surface
phonon polaritons", QUANTUM ELECTRONICS
AND LASER SCIENCE, 2003. QELS.
POSTCONFERENCE DIGEST JUNE 1-6, 2003, 1
juin 2003 (2003-06-01), - 6 juin 2003 (2003-06-06),
pages 341-343, XP010692064, IEEE,
PISCATAWAY, NJ, USA ISBN: 978-1-55752-749-3**
• **SIZOV F ET AL: "THz detectors", PROGRESS IN
QUANTUM ELECTRONICS, vol. 34, no. 5,
septembre 2010 (2010-09), pages 278-347,
XP027218165, Elsevier Science Ltd, UK ISSN:
0079-6727, DOI:
10.1016/j.pquantelec.2010.06.002 [extrait le
2010-06-04] cité dans la demande**

EP 2 676 301 B1

## Description

### Domaine technique de l'invention

La présente invention concerne une cellule de détection térahertz et un détecteur pour radiations térahertz comprenant une ou plusieurs desdites cellules, ainsi qu'une méthode de détection térahertz.

### Etat de l'art

Le domaine térahertz est généralement défini par les radiations dont la fréquence est comprise entre 0.1 et 30 THz. Cette bande de fréquence fait la jonction entre le domaine de l'électronique et le domaine de la photonique. Les dispositifs dans le domaine térahertz se heurtent à des limites de fonctionnement intrinsèques : les fréquences de travail sont trop élevées pour des composants basés sur l'électronique et les énergies sont trop faibles pour travailler efficacement avec des photons. Néanmoins, ce domaine de fréquences possède un fort potentiel applicatif, par exemple dans le domaine de l'imagerie ou des télécommunications, dans lequel les plages de fréquence habituellement attribuées aux télécoms arrivent à saturation. Notamment, l'attribution des plages de fréquences est d'ores et déjà saturée jusqu'à 0.3 THz au États-Unis. Ce potentiel d'applications active les travaux notamment sur le développement de photodétecteurs permettant la détection de radiations dans cette gamme de fréquence.

Les détecteurs THz peuvent se diviser en deux grandes familles, les détecteurs incohérents qui sont sensibles à l'intensité du rayonnement, et les détecteurs cohérents, sensibles à l'amplitude du rayonnement et donnant accès à sa phase. Les articles de F. Sizov et A. Rogalski ('THz detectors', Progress in Quantum Electronics 34(5), 278-347 (2010)), F. Sizov ('THz radiation sensors', Opto-electronics Review 18(1), 10-36) et le livre de J.L. Coutaz (Optoélectronique THz, EDP Science (2008)) par exemple proposent des revues documentées sur les détecteurs THz existants. Les détecteurs cohérents utilisent la technique d'hétérodynage, dans laquelle le signal THz détecté est mélangé à un signal issu d'un oscillateur local dont la fréquence est connue. Les deux signaux sont ensuite mixés pour obtenir un signal dont la fréquence est bien plus faible (typiquement dans les GHz), qui peut être ensuite amplifié par des amplificateurs bas bruit. L'information sur l'amplitude et la phase du signal THz est conservée. Cette conversion est nécessaire puisqu'il n'existe pas encore d'amplificateurs THz. Cette technique, qui permet notamment par rapport à la détection directe ou incohérente de détecter la modulation de fréquence et de phase, présente une excellente sensibilité et un meilleur rapport signal sur bruit puisque le bruit dominant est issu de la fluctuation du signal provenant de l'oscillateur local, plutôt que le bruit de fond. Toutefois, de fortes contraintes sur le signal détecté et le signal issu de l'oscillateur local doivent être respectées pour mettre en place ce type de détection, qui rendent difficile le développement de matrices composées de détecteurs de ce type pour l'imagerie. Parmi les détecteurs directs, on connaît notamment les détecteurs thermiques, par exemple cellules de Golay, détecteurs pyroélectriques, bolomètres et micro-bolomètres, les diodes Schottky, et les antennes photo-conductrices. À titre d'exemple, la demande US 2008/0315098 décrit une antenne photoconductrice composée d'une ligne de transmission formée de deux conducteurs métalliques coplanaires déposée sur un semi-conducteur isolant. Une partie de cette ligne est utilisée comme antenne dans le domaine THz. Ce dispositif est destiné à l'échantillonnage temporel ultra-rapide grâce à une photo-génération par un laser visible La sensibilité des détecteurs fonctionnant à température ambiante ne dépasse pas quelques $10^4$ V/W pour une puissance équivalente de bruit (ou NEP selon l'abréviation de l'expression anglo-saxonne « noise équivalent power ») supérieure à quelques $10^{-11}$/Hz$^{1/2}$. Parmi les détecteurs directs, les détecteurs les plus performants fonctionnent à température cryogénique.

Un objet de la présente invention consiste à présenter un détecteur térahertz direct, fonctionnant à température ambiante et présentant une bonne sensibilité ainsi qu'une faible puissance équivalente de bruit. Le détecteur décrit dans la présente demande est basé sur l'utilisation de phonons polariton d'interface.

### Résumé de l'invention

Selon un premier aspect, l'invention concerne une cellule de détection térahertz pour la détection de radiations de fréquences comprises dans une bande spectrale de détection donnée, comprenant :

- un cristal semi-conducteur polaire présentant une bande de Reststrahlen recouvrant ladite bande spectrale de détection et présentant au moins une interface avec un milieu diélectrique;
- des moyens de couplage permettant le couplage résonant d'un phonon polariton d'interface (IPhP) supporté par ladite interface et d'une radiation incidente de fréquence comprise dans ladite bande spectrale de détection; et
- au moins une première et une seconde bornes de connexion en contact électrique avec respectivement une première et une seconde extrémités opposées de ladite interface et destinées à être connectés à un circuit électrique de lecture pour la mesure de la variation d'impédance du cristal entre lesdites extrémités opposées de l'interface.

L'effet de résonance de la fonction diélectrique d'un cristal polaire dans la bande fréquentielle dite de Reststrahlen du cristal est ainsi utilisé pour créer un détecteur térahertz d'efficacité remarquable et fonctionnant à température ambiante. La variation d'impédance résultant de l'absorption par les porteurs libres du cristal des phonons polaritons d'interface excités par l'onde térahertz incidente est mesurée pour détecter l'intensité lumineuse incidente sur la cellule de détection.

Avantageusement, le cristal polaire présente au moins deux interfaces avec un milieu diélectrique, lesdites interfaces étant suffisamment rapprochées pour permettre le couplage de phonons polaritons d'interface se propageant sur chacune des interfaces. Le couplage de deux modes phonons polaritons d'interface permettra d'accentuer encore le confinement du champ électromagnétique et d'améliorer l'efficacité du détecteur, notamment en rendant plus sensible la variation d'impédance dans le cristal semi-conducteur.

Typiquement, la distance entre les deux interfaces pourra être inférieure à une centaine de nanomètres.

Selon un exemple, le cristal semi-conducteur polaire est un semi-conducteur III-V, par exemple de l'arséniure de gallium (GaAs), de l'arséniure d'aluminium (AlAs), du phosphure d'indium (InP), de l'arséniure d'indium (InAs), du phosphure de gallium (GaP), du nitrure de galium (GaN), etc. Selon un autre exemple, le cristal semi-conducteur polaire est un semi-conducteur II-VI, par exemple du Sélénium de Zinc (ZnSe), du tellurure de mercure (HgTe), du tellurure de Cadmium (CdTe), etc. ou un semi-conducteur I-VII, par exemple chlorure de sodium (NaCl), bromure de potassium (KBr), etc. Selon un autre exemple, le cristal semi-conducteur polaire est un semi-conducteur IV-IV comme le carbure de silicium (SiC). Par ailleurs, les alliages ternaires (à trois éléments, comme AlGaAs par exemple), les alliages quaternaires (à quatre éléments, par exemple InGaAlAs) ou plus, peuvent également être utilisés. Dans la suite de la description, le terme cristal semi-conducteur polaire regroupe l'ensemble de ces matériaux.

Selon une variante, le cristal polaire est dopé. La génération de porteurs libres dans le cristal polaire permet d'élargir et/ou de décaler la bande de résonance de la fonction diélectrique.

Selon un premier mode de réalisation de la cellule de détection selon l'invention, le cristal polaire est structuré pour former une ou plusieurs lames de cristal formant chacune une antenne optique destinée au couplage avec la radiation incidente, les grandes faces de chacune desdites lames formant deux interfaces avec un milieu diélectrique, les bornes de connexion étant en contact électrique avec deux extrémités opposées desdites lames.

Selon un exemple, le cristal polaire est structuré pour former un ensemble de plusieurs lames, agencées selon une direction principale.

Selon un autre exemple, le cristal polaire est structuré pour former un ensemble de plusieurs lames, agencées selon deux directions sensiblement perpendiculaires.

Selon un exemple, le cristal polaire est structuré pour former un ensemble de plusieurs lames identiques, la forme et les dimensions des lames étant alors optimisées pour une bande spectrale de détection fine.

Selon un autre exemple, le cristal polaire est structuré pour former un ensemble de plusieurs lames et une partie au moins des lames présente une forme différente de celle des autres, permettant d'élargir la bande de fréquence de détection.

Selon une première variante du premier mode de réalisation, la ou lesdites lames sont agencées perpendiculairement à un substrat, ledit substrat étant destiné à être agencé dans un plan perpendiculaire au plan d'incidence de la radiation incidente.

Par exemple, le substrat est lui-même formé en cristal polaire et la ou lesdites lames sont formées par gravure dans le substrat. La cellule de détection comprend alors une première borne de connexion en contact avec le substrat, et pour chaque lame, un deuxième borne de connexion en contact avec le bord de la lame opposé au substrat, l'ensemble des deuxièmes bornes de connexion étant connectées électriquement dans le cas d'une pluralité de lames.

Selon un autre exemple, la cellule de détection comprend pour chaque lame de cristal une première borne de connexion en contact avec un premier bord de la lame adjacent au substrat et une deuxième borne de connexion en contact avec un deuxième bord de la lame adjacent au substrat et opposé au premier bord, l'ensemble des premières bornes de connexion d'une part et des deuxièmes bornes de connexion d'autre part étant connectées dans le cas d'une pluralité de lames.

Selon une deuxième variante du premier mode de réalisation, la ou lesdites lames sont agencées dans un plan et forment une membrane suspendue sur un substrat, le plan de la membrane étant destiné à être agencé dans un plan perpendiculaire au plan d'incidence de la radiation incidente.

Par exemple, la cellule comprend pour chaque lame une première borne de connexion en contact électrique avec un premier bord de la lame disposé sur le substrat et une deuxième borne de connexion en contact électrique avec un deuxième bord de la lame disposé sur le substrat et opposé au premier bord, l'ensemble des premières bornes de connexion d'une part et des deuxièmes bornes de connexion d'autre part étant connectés dans le cas d'une pluralité de lames.

Selon un deuxième mode de réalisation d'une cellule de détection selon l'invention, le cristal polaire forme au moins une couche mince entourée d'au moins une première et une deuxième couches barrières en matériau semi-conducteur diélectrique à fort énergie de gap de façon à former avec la couche en cristal polaire au moins un puits quantique.

Par exemple, les moyens de couplage comprennent un ensemble de nanoantennes optiques et un miroir de manière à former une cavité de résonance optique à l'intérieur de laquelle se trouve ledit puits quantique.

Avantageusement, les moyens de couplage comprennent en outre un espaceur pour adapter la largeur de ladite cavité de résonance optique.

La cellule selon le deuxième mode de réalisation peut comprendre au moins une première et une seconde bornes de connexion en contact électrique avec deux bords opposés de la couche mince en cristal polaire.

Selon un deuxième aspect, l'invention concerne un détecteur térahertz comprenant une ou plusieurs cellules de détection selon le premier aspect et un circuit électrique de lecture apte à mesurer la variation d'impédance du cristal entre lesdites bornes de connexion de chacune des cellules de détection.

Selon un troisième aspect, l'invention concerne une méthode de détection d'une radiation incidente de fréquence térahertz comprise dans la bande de Reststrahlen d'un cristal polaire semi-conducteur comprenant les étapes de :

- couplage résonant de la radiation de fréquence térahertz incidente et d'un phonon polariton d'interface à une interface du cristal polaire et d'un matériau diélectrique;
- mesure de la variation d'impédance du cristal entre deux extrémités opposées de ladite interface, résultant de l'absorption par les porteurs libres du cristal des phonons polaritons d'interface ainsi excités.

**Brève description des figures**

D'autres caractéristiques et avantages de l'invention apparaîtront à la lecture de la description qui suit, illustrée par les figures sur lesquelles :

La Figure 1 est un diagramme illustrant schématiquement une mise en oeuvre d'un détecteur selon l'invention.

Les Figures 2A et 2B sont des courbes montrant respectivement l'évolution de la partie réelle et de la partie imaginaire de la fonction diélectrique en fonction de la longueur d'onde pour deux niveaux de dopage dans le GaAs.

Les Figures 3A à 3D illustrent une cellule de détection térahertz selon un premier mode de réalisation de l'invention, selon deux variantes.

La Figure 4A représente sous forme d'un schéma le couplage de phonons polaritons d'interface dans cellule de détection térahertz selon le premier mode de réalisation de l'invention et la figure 4B illustre la courbe de réflectivité en fonction de la longueur d'onde, calculée dans un dispositif du type de la figure 4A.

La Figure 5 représente l'intensité du champ électrique calculé au voisinage d'une interface entre le cristal polaire et un diélectrique dans cellule de détection térahertz selon le premier mode de réalisation de l'invention.

La Figure 6 représente sous forme d'un schéma une variante d'une cellule de détection selon le premier mode de réalisation de l'invention.

Les figures 7A et 7B montrent deux exemples de réalisation d'une cellule de détection du type de celui représenté sur la figure 6.

La Figure 8 illustre cellule de détection térahertz selon un deuxième mode de réalisation de l'invention.

Les figures 9A et 9B montrent deux exemples de réalisation d'une cellule de détection du type de celui représenté sur la figure 8.

**Description détaillée**

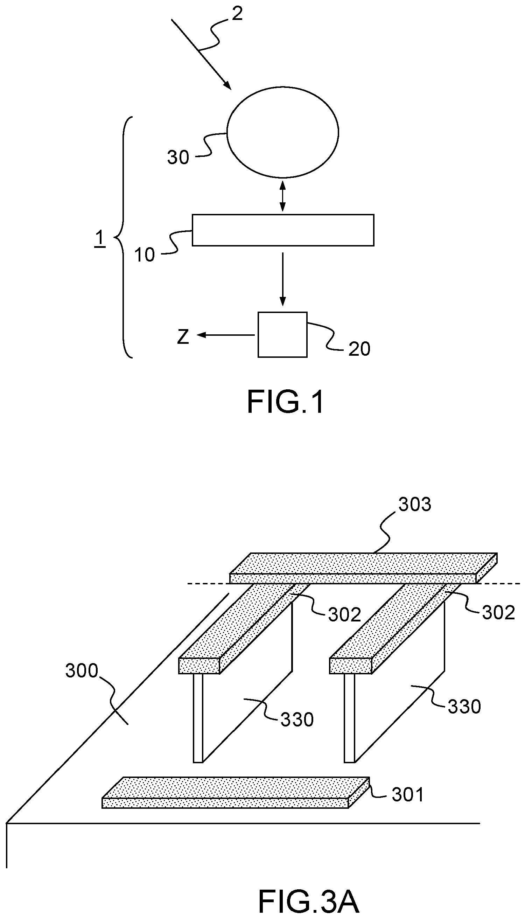

La Figure 1 est un diagramme qui représente de façon schématique un détecteur térahertz selon l'invention dans un exemple de mise en oeuvre. Dans cet exemple, un détecteur térahertz 1 selon l'invention est éclairé par une radiation térahertz incidente 2. Le détecteur 1 comprend généralement une cellule de détection avec un matériau actif 10 comprenant un cristal semi-conducteur polaire et des moyens de couplage 30, ainsi qu'un circuit électrique 20 de lecture apte à mesurer une impédance (Z) et comparable aux circuits de lecture utilisés dans les bolomètres. On pourra, par exemple, mettre en série avec la cellule de détection une source de courant et mesurer la variation de potentiel aux bornes de la cellule.

Le cristal polaire 10 comprend une interface avec un milieu diélectrique, (non représenté sur la figure 1), par exemple du vide, de l'air ou un matériau se comportant comme un diélectrique autour de la fréquence prédéterminée de la radiation térahertz incidente 2.

De manière générale, on appelle cristal polaire un cristal dont les atomes de la maille élémentaire possèdent des électronégativités différentes. Dans des cristaux polaires, le mouvement des atomes les uns par rapport aux autres influence la polarisabilité et donc la fonction diélectrique. Les cristaux polaires présentent une résonance de leur fonction diélectrique liée à des phonons optiques sur une bande de fréquence appelée bande de Reststrahlen. Dans cette bande de Reststrahlen, la partie réelle de la fonction diélectrique est négative. Le matériau se comporte alors optiquement comme un métal (sa réflectivité augmente fortement) et il peut supporter des phonons polaritons de surface, mélanges entre un phonon optique et une onde électromagnétique, le tout se propageant à l'interface entre le cristal polaire et un milieu diélectrique. La résonance de la fonction diélectrique est très bien modélisée par un modèle de Lorentz, et la fonction diélectrique peut s'écrire, selon Born et al. (M. Born et K. Huang "dynamical theory of crystal lattices", Oxford University Press, New York, 1954, (pages 12 et 23)):

$$\varepsilon(\omega) = \varepsilon_\infty \left( 1 + \frac{\omega_L^2 - \omega_T^2}{\omega_T^2 - \omega^2 - i\Gamma\omega} \right) \qquad (1)$$

Où $\omega_L$ et $\omega_T$ sont les fréquences des phonons optiques respectivement longitudinaux et transverses et $\Gamma$ un terme d'amortissement.

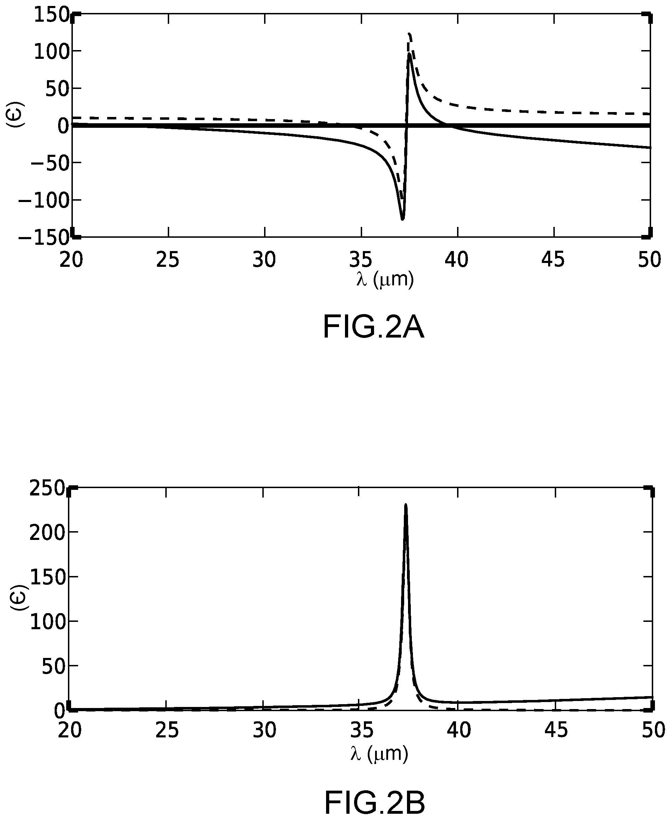

Les figures 2A et 2B représentent en fonction de la longueur d'onde respectivement la partie réelle et la partie imaginaire de la fonction diélectrique de l'arséniure de gallium (GaAs), typique des cristaux polaires, respectivement pour du GaAs pur (courbe en traits pointillés) et du GaAs dopé avec une densité de porteurs de $1{,}5 \, 10^{18}$ cm$^{-3}$ (courbe en trait plein). Les conditions de l'existence de phonons polaritons de surface pour le GaAs sont remplies dans une plage de longueur d'onde restreinte. Par exemple pour une interface GaAs/air, la plage de longueur d'onde où l'onde de surface peut exister est donnée par la relation $\mathrm{Re}(\varepsilon) < -1$, où $\varepsilon$ est la fonction diélectrique de GaAs. Ceci correspond à la plage de longueurs d'onde suivante $35{,}57 \, \mu\mathrm{m} < \lambda < 37{,}30 \, \mu\mathrm{m}$. Pour le GaAs dopé, la plage de longueurs d'onde correspondant aux conditions d'existence de phonons polaritons de surface est élargie.

Tandis que la plupart des études publiées cherchent à éviter les plages de fréquence correspondant à la zone Reststrahlen dans laquelle la résonance engendre des variations extrêmement rapides de la fonction diélectrique, la déposante a montré que l'on pouvait mettre à profit l'existence de ces phonons polaritons d'interfaces pour concevoir des détecteurs extrêmement efficaces dans le domaine des térahertz, comme cela sera mis en évidence dans la suite de la description à travers des exemples de réalisation particuliers.

Plus précisément, la présente invention permet de détecter (convertir en signal électrique) un signal optique dans le domaine du Reststrahlen (frontière infrarouge-THz) du matériau actif, par l'absorption résonante de phonons-polaritons d'interface (IPhP). Ces derniers, portés par la ou les interface(s) d'une lame de cristal polaire (zone active du dispositif) avec le milieu diélectrique adjacent, excitent par absorption les porteurs libres présents dans la lame. Cette augmentation d'énergie cinétique se traduit par une modification de la mobilité des porteurs qui est mesurée dans le circuit extérieur comme une modification de l'impédance du dispositif. Avantageusement, la mesure est faite à très faible courant pour maintenir la population des porteurs libres en régime de mobilité (typiquement un nano ampère) ; les effets d'échauffement du photodétecteur sont donc négligeables ainsi que sa consommation électrique. L'augmentation de l'énergie cinétique des porteurs libres depuis l'équilibre thermodynamique peut modifier fortement leurs conditions de transport. Avantageusement on considérera le cas d'une population formant un gaz bidimensionnel. En effet la transition d'un porteur d'une sous-bande d'énergie à la sous-bande supérieure présente pour l'énergie du porteur, un seuil dû à la conservation de l'énergie. La déposante a montré qu'en plaçant judicieusement une forte proportion de la population sous ce seuil, cette dernière présente une mobilité élevée, qui sera la situation de référence en obscurité. L'éclairement THz augmente la probabilité d'absorption par un porteur libre des IPhP à cause de l'excitation résonante de ces derniers. Il en résulte une augmentation du nombre de transitions intersous-bandes. D'autre part les porteurs dans la sous-bande supérieure relaxent très vite ($\tau < 1\mathrm{ps}$) vers la sous-bande fondamentale par émission d'un IPhP ou d'un phonon optique longitudinal. Ces allers-retours entre les deux sous-bandes se traduisent par une réduction significative de la mobilité, y compris à température ambiante, permettant un fonctionnement de ces photodétecteurs THz à 300K. Par ailleurs, le très faible temps de relaxation des porteurs vers la sous-bande fondamentale se traduit par une rapidité intrinsèque très élevée de ces photodétecteurs.

Les cristaux polaires potentiellement intéressants pour la génération de phonons polaritons de surface dans le domaine des fréquences térahertz sont les semi-conducteurs III-V, par exemple l'arséniure de gallium (GaAs), l'arséniure d'aluminium (AlAs), le phosphure d'indium (InP), l'arséniure d'indium (InAs) et le phosphure de gallium (GaP). Les semi-conducteurs II-VI sont également des cristaux polaires présentant des Reststrahlen dans la bande spectrale d'intérêt, par exemple ZnSe, HgTe, CdTe, de même que les éléments IV-IV comme SiC, les éléments I-VII ou des alliages composés de 3 (ternaire), 4 (quaternaire) ou plus éléments. D'une manière générale, la bande de Reststrahlen de ces matériaux est située dans l'infrarouge lointain, entre $10 \, \mu\mathrm{m}$ et $50 \, \mu\mathrm{m}$, soit entre 6 et 30 térahertz.

Selon une variante, on pourra utiliser un cristal polaire dopé pour augmenter le nombre de porteurs. Le niveau de dopage est déterminé de façon à rendre maximale la sensibilité et réduire le bruit de l'ensemble formé par le détecteur et son circuit de lecture (20). Une concentration typique de porteurs sera de $5 \times 10^{17}$ à $10^{18}$ cm$^{-3}$ pour un transport volumique (3D) et de $5e^{11}$ à $2e^{12}$cm$^{-2}$ pour un gaz bidimensionnel.

Les phonons polaritons d'interface étant des modes évanescents, il n'est cependant pas possible de les coupler avec un champ propagatif incident en éclairant simplement une surface plane. Les moyens de couplage 30 permettent d'assurer le couplage de la radiation térahertz incidente 2 et du champ évanescent du phonon polariton d'interface porté par l'interface entre le cristal polaire et le milieu diélectrique.

Par exemple, dans un mode de réalisation où la radiation térahertz incidente 2 est une onde plane en espace libre, les moyens de couplage peuvent comprendre un prisme en configuration d'Otto, un prisme en configuration de Kretschman, un réseau de couplage, une antenne optique unique, ou une série de telles antennes. Les moyens de couplage peuvent par exemple être obtenus par une structuration du cristal polaire lui-même (antenne optique, réseau) ou par une structuration sous forme de couches minces pour générer une cavité résonante, comme cela sera décrit ultérieurement. Le couplage se traduit alors par une absorption résonante et peut être mis en évidence par une variation de l'impédance aux bornes du cristal polaire supportant les IPhP. On peut ainsi définir une bande spectrale de détection de la cellule de détection, correspondant à la bande de fréquence de couplage définie comme la bande de fréquence comprise dans la bande de Reststrahlen du cristal pour laquelle les moyens de couplages 30 permettent le couplage résonant de la radiation térahertz et d'un phonon polariton d'interface.

Dans un mode de réalisation alternatif, la radiation THz incidente 2 peut être une onde guidée, ou une onde de surface. Les moyens de couplage de la cellule de détection au guide seront un adaptateur d'impédance (« taper ») permettant un transmission optimale du guide au modulateur.

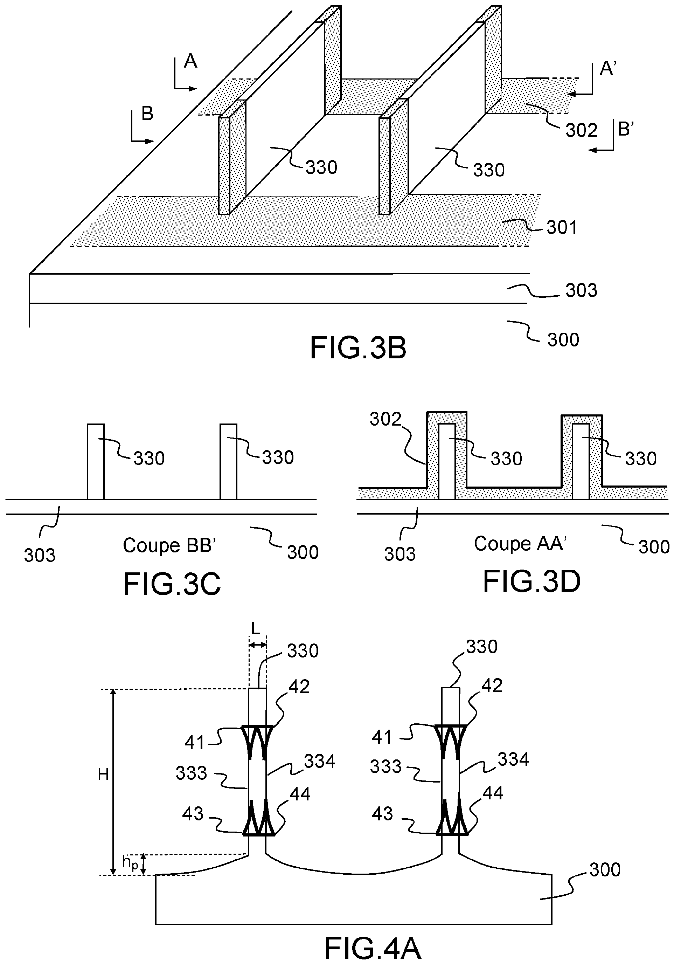

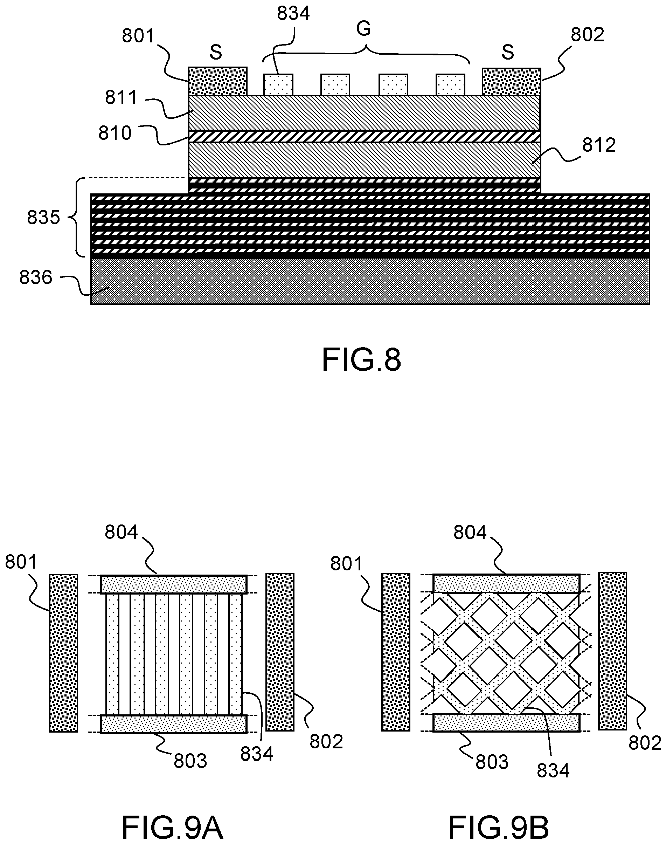

Dans la suite de la description, deux modes de réalisation principaux sont décrits pour la mise en oeuvre d'une cellule de détection THz selon l'invention. Le premier mode de réalisation, décrit au moyen des figures 3 à 7, met en oeuvre une structuration du cristal polaire sous forme d'une lame de cristal formant antenne de couplage pour la radiation incidente, tandis que le second mode de réalisation, décrit au moyen des figures 8 et 9, met en oeuvre une structuration du cristal polaire sous forme d'une couche mince comprise entre deux couches de matériaux semi-conducteur diélectrique à forte énergie de gap par rapport au cristal polaire pour former un puits quantique., cet ensemble de couches étant placé au sein d'un cavité optique.

Des exemples de réalisation d'une cellule de détection THz selon le premier mode de réalisation sont décrits dans un premier temps.

Les Figures 3A à 3D illustrent deux exemples d'une cellule de détection THz selon le premier mode de réalisation.

Dans ces exemples, le cristal polaire est structuré pour former une ou plusieurs lame(s) de cristal 330. La partie active de la cellule de détection est ainsi formée de lames de semi-conducteur polaire (par exemple GaAs), préférentiellement très fines (épaisseur inférieure à 100nm) dont les grandes faces sont en contact avec un milieu diélectrique. Ces interfaces supportent dans le domaine du Restsrahlen du semi-conducteur utilisé des phonons polaritons d'interface (IPhP). Les conditions aux limites imposées aux extrémités de ces faces ainsi que le couplage entre les IPhP supportés par chaque face, permettent de former un résonateur pour un choix donné des dimensions de la lame, essentiellement sa largeur et sa hauteur Une absorption quasi-totale de l'onde THz à la résonance peut alors être obtenue. Chaque lame forme ainsi une antenne optique pour le couplage avec la radiation incidente. Par antenne optique, on entend généralement un élément capable de transférer l'énergie d'une radiation incidente vers un volume plus confiné. Les nanoantennes optiques sont largement étudiées et l'article de L.Novotny et al. (« Antennas for light », nature photonics, Vol 5, February 2011) en fait une très bonne description. Ici, la lame de cristal polaire est dimensionnée de telle sorte à former un résonateur dont les dimensions sont ajustées en fonction des propriétés fréquentielles recherchées pour le couplage. Le résonateur crée un champ évanescent qui va permettre le couplage avec la radiation incidente permettant de confiner l'énergie de l'onde incidente.

Les propriétés fréquentielles du couplage peuvent alors être ajustées en choisissant les dimensions des lames. Le choix d'un ensemble de lames pourra permettre par exemple de couvrir une plus grande surface de détection. On pourra alors choisir des lames de forme et de dimensions identiques pour optimiser le couplage dans une bande spectrale de détection fine, ou au contraire, varier la forme et/ou les dimensions des lames pour élargir la bande de spectrale de détection. Par exemple, on pourra dans le cas de lames de cristal, choisir des lames dont les grandes faces sont carrées ou rectangulaires et avec des dimensions différentes. Par ailleurs, il est possible de prévoir un agencement périodique de ces antennes, par exemple pour faciliter la fabrication du composant ; cependant, la périodicité ainsi que la densité dans la répartition des antennes n'ont que peu d'effet sur le couplage, le couplage étant obtenu par le seul effet du rayonnement du champ évanescent par l'antenne. Cependant, on cherchera à ne pas espacer trop les antennes les unes des autres, afin de ne pas exciter d'ordres diffractés. Typiquement, les antennes seront distantes d'une valeur inférieure à la longueur d'onde. Enfin, on pourra choisir de disposer les antennes selon une direction principale. Alternativement, on pourra choisir de les disposer selon deux directions sensiblement perpendiculaires, de façon à supprimer la sensibilité du composant à la polarisation de la radiation térahertz incidente.

Dans l'exemple de la figure 3A, les lames 330 sont réalisées par exemple par gravure anisotrope d'un cristal polaire massif (par exemple sur un substrat 300 de GaAs). Deux types de contacts ohmiques formant les bornes de connexion de la cellule sont réalisés pour la mesure de l'impédance. Un premier (301) est déposé directement sur le substrat dopé, l'autre (302) est déposé au sommet de chaque lame. Une barrette collectrice 303 est réalisée pour collecter les courants de l'ensemble des contacts 302. L'impédance du dispositif est alors mesurée entre le contact 301 et la barrette collectrice 303.

Dans l'exemple représenté au moyen des figures 3B à 3D, les lames 330 sont par exemple réalisées par gravure anisotrope d'un cristal polaire épitaxié (GaAs dans l'exemple) sur une couche d'arrêt 303, par exemple formée en AlGaAs, permettant un arrêt de la gravure sur cette couche. L'impédance du dispositif est mesurée entre les contacts électriques 301 et 302 formant les bornes de connexion de la cellule de détection et réalisés à chaque extrémité des lames. Avantageusement les contacts sont réalisés grâce à un dépôt métallique formant deux bandes continues connectant les extrémités des lames et posées sur la couche d'arrêt 303. La structure montrée au moyen des figures 3B à 3D est ainsi réalisée sur un empilement de couches épitaxiées associant différents matériaux et différents niveaux de dopage pour permettre à la fois un arrêt de la gravure des lames 330 sur la couche dite d'arrêt 303 ainsi qu'une isolation électrique des lames 330 constituant la zone active par rapport au substrat 300 et des bandes métalliques constituant les prises de contacts (301 et 302). Un exemple d'empilement de couches épitaxiées est donné dans le tableau 1 ci-dessous :

Tableau 1

| Couche | Matériau | Niveau de dopage | Epaisseur |
|--------|----------|------------------|-----------|
| Active | GaAs | $N_D$ = 1e18 cm$^{-3}$ | 2 $\mu$m |
| Arrêt | AlGaAs | nid | 0.1 $\mu$m |
| Substrat | GaAs | nid | 350 $\mu$m |

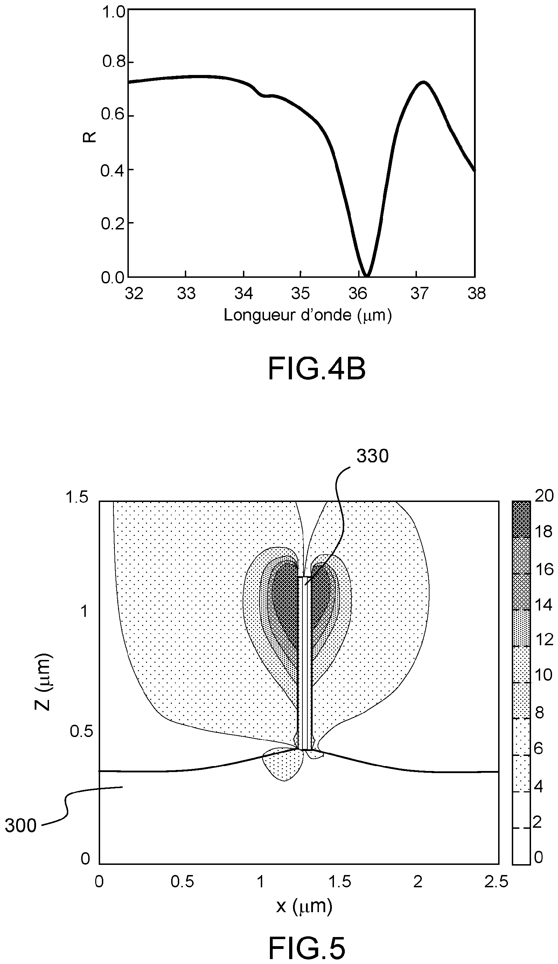

Les figures 4A, 4B et 5 montrent plus en détail le mécanisme d'absorption de la radiation incidente dans l'exemple montré sur la figure 3A. Chaque lame de cristal 330 présente une section de forme rectangulaire qui s'élève perpendiculairement à la surface d'un substrat 300. La lame 330 comprend des parois parallèles 333, 334 formant chacune une interface entre le cristal polaire et le milieu diélectrique avoisinant, dans cet exemple le vide ou l'air. Alternativement, la lame en cristal polaire peut être entourée par un matériau diélectrique, par exemple un matériau diélectrique organique de type résine. Les interfaces 333, 334 supportent des phonons polaritons d'interface 41-44. Chaque lame en cristal 330 possède des dimensions (hauteur H et largeur L) très inférieures à la longueur d'onde de la radiation térahertz incidente 2.

Avantageusement, la largeur L est suffisamment faible pour permettre un couplage entre des phonons polaritons d'interface 41-43 se propageant à l'interface 333 et des phonons polaritons 42-44 se propageant à l'interface 334 des deux cotés des lames 330. Ceci permet d'augmenter le confinement du champ électromagnétique par augmentation de l'indice effectif du mode. Typiquement, la déposante a montré qu'une largeur des lames inférieure à une centaine de nanomètres permet de réaliser un tel couplage.

Lorsque la lame est de forme sensiblement rectangulaire, seuls des modes verticaux existeront et l'on cherchera à optimiser la hauteur H de la lame en fonction de la longueur d'onde de couplage recherchée. D'une manière générale, la hauteur H des antennes optiques sera choisie de l'ordre de $\lambda_r/4n_{eff}$ où $\lambda_r$ est la fréquence de résonance et $n_{eff}$ l'indice effectif du mode. L'indice effectif dépend fortement de la nature du cristal polaire, et de son niveau de dopage. Par exemple, pour un cristal polaire en GaAs, la longueur d'onde de résonance est proche de 35.5 $\mu$m. L'épaisseur de la lame optique pourra être choisie entre 60 et 80 nm, la hauteur des antennes de l'ordre de 800 nm, l'indice effectif étant compris entre 7.5 et 10 pour un dopage de 1.5 10$^{18}$ cm$^{-3}$. Dans le cas d'une lame de forme carrée, le résonateur pourra présenter à la fois des modes horizontaux et verticaux et les paramètres d'optimisation du résonateur se trouveront modifiés. Une optimisation fine du résonateur peut être effectuée numériquement à l'aide de codes de type « Rigourous Coupled Wave Analysis » (RCWA), décrit notamment dans L. Li, Journal of Optical Society of America A, 14(10), 2758 (1997), ou «Rigourous Maxwell with Constitutive B-spline approximation » (RMCB) décrite dans P . Bouchon, Journal of Optical Society of America A, 27(4), 696 (2010). Des codes commerciaux (Reticolo) peuvent aussi être utilisés. La fréquence et l'intensité du couplage peuvent ainsi être ajustés en modifiant la largeur L et la hauteur H des lames 330 autour de valeurs nominales, permettant ainsi d'ajuster la bande fréquentielle de couplage et donc la bande spectrale de détection du détecteur térahertz.

A titre d'exemple, la figure 4B illustre la réflectivité R d'un réseau selon la réalisation représentée sur la figure 4A, avec un cristal polaire en GaAs. Pour le calcul de la réflectivité, les paramètres suivants ont été considérés : période des murs 330 égale à 2.5 $\mu$m, hauteur des murs égale à 2,8 $\mu$m, hauteur $h_p$ égale à 600 nm, largeur des murs égale à 65 nm. Sur cette figure, on observe que la réflectivité tombe à zéro à une longueur d'onde proche de 36 $\mu$m (correspondant à une fréquence de 8,3 Térahertz incluse dans la bande de Restrahlen du GaAs), du fait du couplage résonant entre l'onde incidente térahertz et les IPhP.

La figure 5 met en évidence le confinement du champ électrique dans une structure du type de celle des figures 3A et 4. L'intensité du champ électrique selon la direction perpendiculaire aux interfaces 333 et 334, et normalisée par l'intensité du champ électrique incident, est calculée (RCWA, RMCB ou Reticolo) pour un agencement périodique d'antennes résonantes. La figure 5 représente uniquement une période (2.5 $\mu$m) de la structure périodique. L'antenne représentée est en GaAs dopé à 1.5 $10^{18}$ cm$^{-3}$, elle mesure 800 nm de haut, 80 nm de large. L'indice effectif élevé du mode couplé entre les deux interfaces 333, 334 permet de confiner le champ électromagnétique dans un volume très faible. Le confinement du champ permet une plus grande excitation des modes d'interface et donc une exaltation de l'absorption des IPhP par les porteurs libres présents dans les lames. La déposante a ainsi montré qu'à la résonance, pour un cristal polaire en GaAs dopé, le volume du mode couplé est de l'ordre de $\lambda^3/10^6$ où $\lambda$ est la longueur d'onde de la radiation THz incidente.

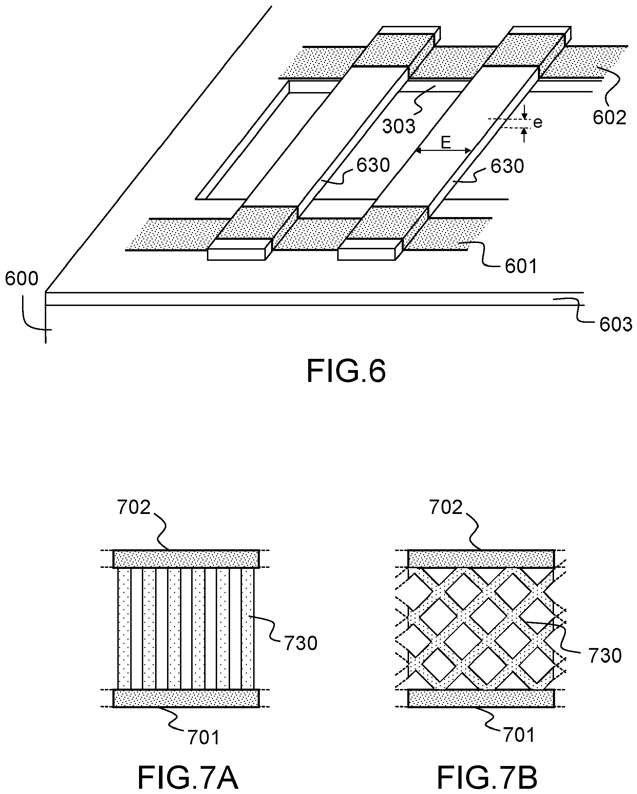

La figure 6 représente une variante de détecteur selon le premier mode de réalisation. Selon cette variante, le cristal polaire est structuré pour former un ensemble lames de cristal polaire 630 séparées par des fentes et qui forment une membrane structurée, suspendue au-dessus d'un substrat 600. La géométrie des lames de cristal polaire 630 comprises entre deux fentes correspond à la géométrie des lames 330 du mode de réalisation précédemment décrit. Comme dans les exemples des figures 3A et 3B, les lames de cristal 630 forment des antennes de couplage pour coupler la radiation incidente avec les phonons polaritons d'interfaces supportés aux interfaces des lames de cristal avec le milieu diélectrique environnant. L'épaisseur de la membrane e correspond à la largeur L des murs 330 et la largeur E des lames 630 correspond à la hauteur H des lames 330. De même que pour le mode de réalisation précédent, la périodicité a peu d'importance. L'impédance du dispositif est mesurée entre les contacts électriques 601, 602 réalisés à chaque extrémité des lames.

La structure représentée sur la figure 6 est par exemple réalisée sur un empilement de couches épitaxiées associant différents matériaux et différents niveaux de dopage pour permettre un arrêt de la gravure de la couche active d'une part et du substrat d'autre part lors de la réalisation de la membrane, ainsi qu'une isolation électrique des lames constituant la zone active par rapport au substrat 600. Un exemple d'empilement de couches épitaxiées est donné dans le tableau 2 ci-dessous :

Tableau 2

| Couche | Matériau | Niveau de dopage | Epaisseur |
|---|---|---|---|
| Active | GaAs | $N_D$ = 1e18 cm$^{-3}$ | 50 nm |
| Arrêt | AlGaAs | nid | 0.1 $\mu$m |
| Substrat | GaAs | nid | 350 $\mu$m |

Les lames sont par exemple réalisées en quatre étapes (1) structuration de la couche active 630 (GaAs dans l'exemple) suivie ou précédée par (2) la réalisation d'une membrane par ouverture dans le substrat 600 d'une fenêtre puis (3) retrait de la couche d'arrêt 603 dans la fenêtre (face arrière) et enfin (4) retrait de la couche active sur la face avant en dehors de la fenêtre. L'impédance du dispositif est mesurée entre les contacts électriques 601, 602 réalisés à chaque extrémité des lames.

Les figures 7A et 7B représentent deux exemples d'agencement des lames de cristal dans les différentes variantes illustrées par les figures 3B et 6 (contacts électriques 701, 702 formés aux extrémités des lames). La structure présentée sur la figure 7A comporte des lames 730 agencées principalement selon une direction. Cette structure est donc sensible à la polarisation de la lumière incidente. Une structuration selon deux directions est possible (figure 7B) pour obtenir un dispositif insensible à la polarisation. Dans ce cas, les lames sont agencées selon deux directions sensiblement perpendiculaires.

Par ailleurs, en modifiant la hauteur et/ou l'épaisseur des lames, il est possible de modifier la longueur d'onde de la résonance. Ainsi en réalisant un dispositif dont les lames ne présentent pas toutes la même géométrie il est possible d'élargir la réponse spectrale de détection du dispositif. D'autre part en regroupant les connexions électriques des lames de même forme, il est possible de réaliser un détecteur THz polychromatique, c'est à dire fournissant un signal électrique spécifique à chacune des longueurs d'onde de résonance.

Un exemple de réalisation d'un détecteur THz selon le second mode de réalisation est ensuite décrit au moyen des figures 8 , 9A et 9B (vues de dessus de la figure 8 selon deux variantes).

Dans ce mode de réalisation, le cristal polaire forme une couche mince 810 dans un empilement successif de couches minces en matériaux semi-conducteur et les moyens de couplage sont formés par un ensemble d'antennes optiques 834 associé à un miroir 836 de manière à former une cavité optique à l'intérieur de laquelle est agencé l'empilement des couches minces en matériau semi-conducteur. Avantageusement, un espaceur 835 permet d'ajuster la largeur de la cavité.

Plus précisément, l'empilement de couches minces comprend successivement une première couche barrière 811, la couche mince de cristal polaire 810 et une deuxième couche barrière 812. Les couches barrières 811 et 812 présentent chacune une interface 815, 816 avec le cristal polaire 810 et sont formées en matériaux semi-conducteurs diélectriques à forte énergie de gap par rapport au cristal polaire 810 de manière à ce que l'empilement de la première couche barrière 811, de la couche mince de cristal polaire 810 et de la deuxième couche barrière 812 forme un puits quantique dont les propriétés de transport des porteurs libres sont utilisées pour mesurer l'absorption du rayonnement THZ incident, comme cela sera expliqué par la suite. Les matériaux à grand gap formant les couches 811 et 812 sont choisis en fonction du cristal polaire 810 utilisé. Par exemple, le cristal polaire 810 peut être formé de GaAs et les couches barrières 811 et 812 peuvent être formées d'un alliage AlGaAs à 33% d'aluminium, par exemple $Al_{33}Ga_{67}As$. Avantageusement toutes ces couches seront déposées par épitaxie.

Les épaisseurs des couches 810, 811 et 812 sont dictées par la conception électronique de la structure. En particulier, l'épaisseur de la couche 810 est choisie de manière à ce que l'énergie de transition entre les niveaux d'énergie du puits quantique formé par les couches 811-810-812 soit voisine de l'énergie du mode d'interface supporté par le cristal polaire 810. Par exemple, pour un puits quantique en GaAs et des barrières en $Al_{33}Ga_{67}As$, l'énergie visée est 36 meV, ce qui donne une épaisseur de GaAs de 21 à 22 nm.

Les moyens de couplage sont formés dans cet exemple par un ensemble d'antennes optiques 834, avantageusement métalliques, associé à un miroir 836 de manière à former une cavité optique. L'épaisseur de la cavité, qui peut être ajustée par un espaceur 835, ainsi que les paramètres des antennes optiques 834 sont déterminés pour exciter un mode de phonon polariton d'interface aux interfaces 815 et 816 entre le cristal polaire 810 et les couches barrières 811 et 812. La cavité optique permet de concentrer le champ électromagnétique dans le puits quantique en ajustant la taille de l'espaceur 835. Le miroir 836 est par exemple un substrat en GaAs dopé, le dopage permettant de rendre le GaAs réfléchissant aux longueurs d'onde considérées, ou en métal, par exemple en or. La formation de cette cavité permet d'obtenir un facteur 5 d'exaltation sur l'intensité du champ dans la cavité. Aussi, la déposante a montré que l'on pouvait tirer profit du fait que la fonction diélectrique du cristal polaire 810 est proche de zéro à la longueur d'onde du mode d'interface lié au puits quantique. Ceci permet d'avoir un champ très confiné dans le cristal polaire. Par exemple, dans le cas d'un puits quantique en GaAs et de barrières en $Al_{33}Ga_{67}As$, le facteur d'exaltation de l'intensité du champ est de 140.

La structure bénéficie donc de deux effets (cavité et fonction diélectrique proche de 0) pour donner au final un facteur d'exaltation de l'intensité du champ de 700 environ tout en confinant le champ électromagnétique dans le puits quantique.

Avantageusement, une couche de protection (non représentée), par exemple en GaAs est déposée sur la couche barrière 811 pour prévenir l'oxydation de cette couche.

La population du puits quantique est assurée par un apport de porteurs. Cet apport peut être effectué de manière différente, connus de la physique des transistors à effet de champ (HEMT). Par exemple, dans la structure de la figure 8, un plan de dopage (densité $8 \times 10^{12} cm^{-2}$) est ajouté dans la barrière 811. Alternativement, le puits peut être directement dopé, ou un dopage volumique de la couche barrière peut être effectué.

D'autres variantes sur la géométrie des puits peuvent par ailleurs être envisagées. Par exemple, selon une variante, un système formé de plusieurs puits quantiques pourra être utilisé.

Les antennes optiques peuvent être disposées parallèlement entre elles pour former un réseau unidimensionnel métallique (voir figure 9A). Alternativement, un réseau présentant un motif à deux dimensions avec deux séries perpendiculaires d'antennes parallèles (voir figure 9B) peut être agencé pour permettre une structure insensible à la polarisation de la radiation THz incidente. Par exemple, le réseau de couplage 834 peut être formé en or (Au). Avantageusement, une couche d'accroché (non représentée) est interposée entre la couche supérieure de l'empilement et le réseau de couplage 834 pour favoriser l'adhérence des antennes au détecteur. Par exemple, la couche d'accroché peut être formée en titane (Ti). L'espaceur peut être fabriqué par épitaxie sur le substrat de GaAs dopé. L'espaceur 835 peut par exemple être formé d'un alliage AlGaAs à 50% d'aluminium. Avantageusement, l'espaceur 835 peut être formé d'une alternance de fines couches (super-réseau) de GaAs et d'AlAs. Dans le cas d'une technologie reportée, cette couche peut aussi être formée par un autre matériau ($Si_3N_4$, $SiO_2$ par exemple).

De part et d'autre du détecteur deux contacts S (801) et D (802) sont réalisés pour mesurer les variations d'impédance du puits quantique. Ils contactent de façon ohmique (caractéristiques courant-tension linéaire) les porteurs libres du gaz bidimensionnel du puits quantique. Ils sont réalisés selon la technologie connue des contacts de source et drain des transistors HEMT (voir par exemple V. L. Rideout, Solid-State Electronics, Volume 18, Issue 6, 1975, Pages 541-550).

D'autre part les antennes optiques métalliques peuvent être connectées à un contact G (803, 804 sur les figures 9A, 9B) qui permet par application d'une tension de modifier la densité de porteurs dans le gaz bidimensionnel et la distance en énergie entre les sous-bandes du puits quantique. Cette dernière commande permet de décaler, dans le domaine du Reststrahlen, la longueur d'onde de l'absorption résonante du détecteur.

Une cellule de détection selon le deuxième mode de réalisation tels que décrit sur la Figure 8 est par exemple fabriquée selon les étapes de fabrication suivantes. Sur un substrat de GaAs dopé 836, les couches 835, 812, 810, et 811 sont déposées par épitaxie. Ensuite, une lithographie UV est réalisée dans une résine photosensible pour définir la géométrie du réseau. La couche de protection est gravée chimiquement, et les couches constituant les antennes optiques (couches d'accroché et métallique 834) sont déposées par évaporation.

Par rapport au premier mode de réalisation de l'invention, le détecteur selon le deuxième mode de réalisation permet notamment un plus grand confinement du champ électromagnétique conduisant à une absorption plus efficace et une commande électrique permet de décaler dans la bande du reststrahlen la longueur d'onde de l'absorption résonante.

Bien que décrite à travers un certain nombre d'exemples de réalisation détaillés, la cellule de détection pour radiation térahertz selon l'invention comprend différentes variantes, modifications et perfectionnements qui apparaîtront de façon évidente à l'homme de l'art, étant entendu que ces différentes variantes, modifications et perfectionnements font partie de la portée de l'invention, telle que définie par les revendications qui suivent.

**Revendications**

1. Cellule de détection térahertz (1) pour la détection de radiations de fréquences comprises dans une bande spectrale de détection donnée, comprenant :

   - un cristal semi-conducteur polaire (10) présentant une bande de Reststrahlen recouvrant ladite bande spectrale de détection et présentant au moins une interface avec un milieu diélectrique;
   - des moyens de couplage (30) permettant le couplage résonant d'un phonon polariton d'interface (IPhP) supporté par ladite interface et d'une radiation incidente (2) de fréquence comprise dans ladite bande spectrale de détection; et
   - au moins une première et une seconde bornes de connexion (301, 302) en contact électrique avec respectivement une première et une seconde extrémités opposées de ladite interface et destinées à être connectés à un circuit électrique de lecture pour la mesure de la variation d'impédance du cristal entre lesdites extrémités opposées de l'interface.

2. Cellule de détection selon la revendication 1, dans lequel ledit cristal polaire présente au moins deux interfaces avec un milieu diélectrique, lesdites interfaces étant suffisamment rapprochées pour permettre le couplage de phonons polaritons d'interface se propageant sur chacune des interfaces (333, 334).

3. Cellule de détection selon la revendication 2, dans lequel la distance entre les deux interfaces est inférieure à une centaine de nanomètres.

4. Cellule de détection selon l'une quelconque des revendications précédentes, dans lequel le cristal polaire (10) est dopé.

5. Cellule de détection selon l'une quelconque des revendications précédentes, dans lequel le cristal polaire est structuré pour former une ou plusieurs lames de cristal (330, 630) formant chacune une antenne optique destinée au couplage avec la radiation incidente, les grandes faces de chacune desdites lames formant deux interfaces avec un milieu diélectrique, les bornes de connexion étant en contact électrique avec deux extrémités opposées desdites lames.

6. Cellule de détection selon la revendication 5, dans lequel le cristal polaire est structuré pour former un ensemble de plusieurs lames, agencées selon une direction principale.

7. Cellule de détection selon la revendication 5, dans lequel le cristal polaire est structuré pour former un ensemble de plusieurs lames, agencées selon deux directions sensiblement perpendiculaires.

8. Cellule de détection selon l'une quelconque des revendications 5 à 7, dans lequel le cristal polaire est structuré pour former un ensemble de plusieurs lames (330, 630) identiques.

9. Cellule de détection selon l'une quelconque des revendications 5 à 7, dans lequel le cristal polaire est structuré pour former un ensemble de plusieurs lames (330, 630) et une partie au moins des lames présentent une forme différente de celle des autres, permettant d'élargir la bande de fréquence de détection.

10. Cellule de détection selon l'une quelconque des revendications 5 à 9 comprenant un substrat (300), et dans lequel la ou lesdites lames sont agencées perpendiculairement audit substrat (300).

**11.** Cellule de détection selon la revendication 10, dans lequel le substrat est en cristal polaire et la ou lesdites lames sont formées par gravure dans le substrat (300), la cellule de détection comprenant une première borne de connexion (301) en contact avec le substrat, et pour chaque lame, un deuxième borne de connexion (302) en contact avec le bord de la lame opposé au substrat, l'ensemble des deuxièmes bornes de connexion étant connectées électriquement dans le cas d'une pluralité de lames.

**12.** Cellule de détection selon la revendication 10, comprenant pour chaque lame une première borne de connexion (301) en contact avec un premier bord de la lame adjacent au substrat et une deuxième borne de connexion (302) en contact avec un deuxième bord de la lame adjacent au substrat et opposé au premier bord, l'ensemble des premières bornes de connexion d'une part et des deuxièmes bornes de connexion d'autre part étant connectées dans le cas d'une pluralité de lames.

**13.** Cellule de détection selon l'une quelconque des revendications 5 à 9 comprenant un substrat (600), et dans lequel la ou lesdites lames sont agencées dans un plan et forment une membrane suspendue sur ledit substrat (600), le plan de la membrane étant sensiblement parallèle à celui dudit substrat.

**14.** Cellule de détection selon la revendication 13, comprenant pour chaque lame une première borne de connexion (601) en contact électrique avec un premier bord de la lame disposé sur le substrat et une deuxième borne de connexion (602) en contact électrique avec un deuxième bord de la lame disposé sur le substrat et opposé au premier bord, l'ensemble des premières bornes de connexion d'une part et des deuxièmes bornes de connexion d'autre part étant connectés dans le cas d'une pluralité de lames.

**15.** Cellule de détection selon l'une quelconque des revendications 1 à 4, dans lequel le cristal polaire forme au moins une couche mince (810) entourée d'au moins une première et une deuxième couches barrières (811, 812) en matériau semi-conducteur diélectrique à forte énergie de gap de façon à former avec la couche en cristal polaire au moins un puits quantique.

**16.** Cellule de détection selon la revendication 15, dans lequel les moyens de couplage (30) comprennent un ensemble de nanoantennes optiques (834) et un miroir (836) de manière à former une cavité de résonance optique à l'intérieur de laquelle se trouve ledit puits quantique.

**17.** Cellule de détection selon la revendication 16, dans lequel les moyens de couplage (30) comprennent en outre un espaceur (835) pour adapter la largeur de ladite cavité de résonance optique.

**18.** Cellule de détection selon l'une quelconque des revendications 15 à 17, comprenant au moins une première et une seconde bornes de connexion en contact électrique avec deux bords opposés de la couche mince en cristal polaire.

**19.** Détecteur térahertz comprenant une ou plusieurs cellules de détection selon l'une quelconque des revendications précédentes et un circuit électrique (20) de lecture apte à mesurer la variation d'impédance du cristal entre lesdites bornes de connexion de chacune des cellules de détection.

**20.** Méthode de détection d'une radiation incidente (2) de fréquence térahertz comprise dans la bande de Reststrahlen d'un cristal polaire semi-conducteur (10) comprenant les étapes de :

- couplage résonant de la radiation de fréquence térahertz incidente (2) et d'un phonon polariton d'interface à une interface du cristal polaire (10) et d'un matériau diélectrique (11);
- mesure de la variation d'impédance du cristal entre deux extrémités opposées de ladite interface, résultant de l'absorption par les porteurs libres du cristal des phonons polaritons d'interface ainsi excités.

**Patentansprüche**

**1.** Terahertz-Sensorzelle (1) zur Detektion von Frequenzstrahlungen, die in einem Spektralband gegebener Detektion enthalten sind, welche Folgendes umfasst:

- ein polarer Halbleiter-Kristall (10), der ein Reststrahlen-Band aufweist, das dieses Detektionsspektralband abdeckt und das mindestens eine Grenzfläche mit einem dielektrischen Medium aufweist;
- Kopplungsmittel (30), die die resonante Kopplung eines Phononpolaritons der Grenzfläche (IPhP) erlauben, unterstützt durch die Grenzfläche und durch eine einfallende Frequenz-Strahlung (2), die in dem Detektionsspektralband enthalten ist; und

- mindestens eine erste und eine zweite Anschlussklemme (301, 302) in elektrischem Kontakt mit einem ersten bzw. einem zweiten Ende gegenüber der Grenzfläche und ausgelegt, um mit einem Ablesestromkreis für die Messung der Impedanzveränderung des Kristalls zwischen den gegenüberliegenden Enden der Grenzfläche verbunden zu werden.

2. Sensorzelle nach Anspruch 1, in der das polare Kristall mindestens zwei Grenzflächen mit einem dielektrischen Medium aufweist, wobei die Grenzflächen nahe genug liegen, um die Kopplung der Phononpolaritons der Grenzfläche zu erlauben, die sich auf jeder der Grenzflächen (333, 334) ausbreiten.

3. Sensorzelle nach Anspruch 2, in der die Distanz zwischen den beiden Grenzflächen geringer als ungefähr hundert Nanometer ist.

4. Sensorzelle nach einem der vorhergehenden Ansprüche, in der der polare Kristall (10) dotiert ist.

5. Sensorzelle nach einem der vorhergehenden Ansprüche, in der der polare Kristall strukturiert ist, um eine oder mehrere Kristalllamellen (330, 630) zu bilden, die jede eine optische Antenne bilden, die zur Kopplung mit der einfallenden Strahlung bestimmt ist, wobei die großen Oberflächen von jeder Lamelle zwei Grenzflächen mit einem dielektrischen Medium bilden, wobei die Anschlussklemmen in elektrischem Kontakt mit beiden gegenüberliegenden Enden der Lamellen stehen.

6. Sensorzelle nach Anspruch 5, in der der polare Kristall strukturiert ist, um eine Gesamtheit aus mehreren Lamellen zu bilden, die in einer Hauptrichtung angeordnet sind.

7. Sensorzelle nach Anspruch 5, in der der polare Kristall strukturiert ist, um eine Gesamtheit aus mehreren Lamellen zu bilden, die in zwei im Wesentlichen senkrechten Richtungen angeordnet sind.

8. Sensorzelle nach einem der Ansprüche 5 bis 7, in der der polare Kristall strukturiert ist, um eine Gesamtheit aus mehreren identischen Lamellen (330, 630) zu bilden.

9. Sensorzelle nach einem der Ansprüche 5 bis 7, in der der polare Kristall strukturiert ist, um eine Gesamtheit aus mehreren Lamellen (330, 630) zu bilden und mindestens ein Teil der Lamellen eine von den anderen Lamellen verschiedene Form aufweisen, wodurch sie erlauben, das Detektionsfrequenzband zu vergrößern.

10. Sensorzelle nach einem der Ansprüche 5 bis 9, die ein Substrat (300) umfasst, und in der die Lamelle oder die Lamellen in diesem Substrat (300) senkrecht angeordnet sind.

11. Sensorzelle nach Anspruch 10, in der das Substrat aus polarem Kristall besteht und die Lamelle oder die Lamellen durch Gravur in dem Substrat (300) gebildet werden, wobei die Sensorzelle eine erste Anschlussklemme (301) in Kontakt mit dem Substrat umfasst, und für jede Lamelle eine zweite Anschlussklemme (302) in Kontakt mit dem Rand der in dem Substrat gegenüberliegenden Lamelle steht, wobei die Gesamtheit der beiden Anschlussklemmen im Fall einer Vielzahl von Lamellen elektrisch verbunden ist.

12. Sensorzelle nach Anspruch 10, die für jede Lamelle eine erste Anschlussklemme (301) in Kontakt mit einem ersten Rand der im Substrat benachbarten Lamelle und eine zweite Anschlussklemme (302) in Kontakt mit einem zweitem Rand der im Substrat benachbarten und dem ersten Rand gegenüberliegenden Lamelle umfasst, wobei für den Fall einer Vielzahl von Lamellen die Gesamtheit der ersten Anschlussklemmen einerseits und der zweiten Anschlussklemmen andererseits verbunden sind.

13. Sensorzelle nach einem der Ansprüche 5 bis 9, die ein Substrat (600) umfasst, und in der die Lamelle oder die Lamellen in einer Ebene angeordnet sind und eine über dem Substrat (600) hängende Membran bilden, wobei die Membranebene im Wesentlichen parallel zu der des Substrats ist.

14. Sensorzelle nach Anspruch 13, die für jede Lamelle eine erste Anschlussklemme (601) in elektrischem Kontakt mit einem ersten Rand der auf dem Substrat verfügbaren Lamelle und eine zweite Anschlussklemme (602) in elektrischem Kontakt mit einem zweiten Rand der auf dem Substrat verfügbaren und dem ersten Rand gegenüberliegenden Lamelle umfasst, wobei für den Fall einer Vielzahl von Lamellen die Gesamtheit der ersten Anschlussklemmen einerseits und der zweiten Anschlussklemmen andererseits verbunden sind.

15. Sensorzelle nach einem der Ansprüche 1 bis 4, bei der das polare Kristall mindestens eine Dünnschicht (810) bildet, die umgeben ist von mindestens einer ersten und einer zweiten Sperrschicht (811, 812) aus dielektrischem Halbleitermaterial von starker Spaltenergie von der Art, um mit der Schicht aus polarem Kristall mindestens einen Quantentopf zu bilden.

16. Sensorzelle nach Anspruch 15, in der die Kopplungsmittel (30) eine Gesamtheit von optischen Nanoantennen (834) und einen Spiegel (836) in der Art umfassen, um einen optischen Resonanzhohlraum zu bilden, in dessen Inneren sich der Quantentopf befindet.

17. Sensorzelle nach Anspruch 16, in der die Kopplungsmittel (30) überdies ein Abstandsstück (835) umfassen, um die Größe des optischen Resonanzhohlraums anzupassen.

18. Sensorzelle nach einem der Ansprüche 15 bis 17, die mindestens eine erste und eine zweite Anschlussklemme in elektrischem Kontakt mit zwei gegenüberliegenden Rändern der dünnen Schicht aus polarem Kristall umfasst.

19. Terahertz-Sensor, der eine oder mehrere Sensorzellen nach einem der vorhergehenden Ansprüche und einen Ablesestromkreis (20) umfasst, der geeignet ist, die Impedanzveränderung des Kristalls zwischen den Anschlussklemmen jeder Sensorzelle zu messen.

20. Verfahren der Detektion einer einfallenden Terahertz-Frequenz-Strahlung (2), die im Reststrahlen-Band eines polaren Halbleiter-Kristalls (10) enthalten ist, welches die Schritte umfasst:

   - resonante Kopplung der einfallenden Terahertz-Frequenz-Strahlung (2) und eines Phononpolaritons der Grenzfläche mit einer Grenzfläche eines polaren Kristalls (10) und eines dielektrischen Materials (11);
   - Messung der Impedanzveränderung des Kristalls zwischen zwei gegenüberliegenden Endstücken der Grenzfläche, die aus der Absorption durch die freien Träger des Kristalls des so stimulierten Phononpolaritons der Grenzfläche resultiert.

## Claims

1. A terahertz detection cell (1) for the detection of radiations of frequencies included in a given spectral detection band, comprising:

   - a semi-conductor polar crystal (10) having a Reststrahlen band covering said spectral detection band and having at least one interface with a dielectric medium;
   - coupling means (30) allowing the resonant coupling of an interface phonon polariton (IPhP) supported by said interface and of an incident radiation (2) of frequency included in said spectral detection band; and
   - at least one first and one second connection terminals (301, 302) in electrical contact respectively with a first and a second opposite ends of said interface and intended to be connected to an electrical reading circuit for the measurement of the impedance variation of the crystal between said opposite ends of the interface.

2. The detection cell as claimed in claim 1, in which said polar crystal has at least two interfaces with a dielectric medium, said interfaces being sufficiently close to allow the coupling of interface phonon polaritons propagating along each of the interfaces (333, 334).

3. The detection cell as claimed in claim 2, in which the distance between the two interfaces is less than a hundred nanometers.

4. The detection cell as claimed in any one of the previous claims, in which the polar crystal (10) is doped.

5. The detection cell as claimed in any one of the previous claims, in which the polar crystal is structured to form one or a plurality of crystal blades (330, 630) each forming an optical antenna intended for coupling with the incident radiation, the large faces of each of said blades forming two interfaces with a dielectric medium, connection terminals being in contact with two opposite ends of said blades.

**6.** The detection cell as claimed in claim 5, in which the polar crystal is structured to form a group of a plurality of blades laid out along a principal direction.

**7.** The detection cell as claimed in claim 5, in which the polar crystal is structured to form a group of a plurality of blades laid out along two substantially perpendicular directions.

**8.** The detection cell as claimed in any one of claims 5 to 7, in which the polar crystal is structured to form a group of a plurality of identical blades (330, 630).

**9.** The detection cell as claimed in any one of claims 5 to 7, in which the polar crystal is structured to form a group of a plurality of identical blades (330, 630) and at least a part of the blades have a different shape from that of the others, allowing the detection frequency band to be widened.

**10.** The detection cell as claimed in any one of claims 5 to 9 comprising a substrate (300), and in which said blade or blades are laid out perpendicular to said substrate (300).

**11.** The detection cell as claimed in claim 10, in which the substrate is of a polar crystal and said blade(s) are formed by etching in the substrate (300), the detection cell comprising a first connection terminal (301) in contact with the substrate, and, for each blade, a second connection terminal (302) in contact with the edge of the blade opposite the substrate, the group of second connection terminals being electrically connected in the case of a plurality of blades.

**12.** The detection cell as claimed in claim 10, comprising, for each blade, a first connection terminal (301) in contact with a first edge of the blade adjacent to the substrate and a second connection terminal (302) in contact with a second edge of the blade adjacent to the substrate and opposite the first edge, the group of first connection terminals on the one hand and second connection terminals on the other hand being connected in the case of a plurality of blades.

**13.** The detection cell as claimed in any one of claims 5 to 9, comprising a substrate (600), and in which the said blade(s) are laid out in a plane and form a membrane suspended over said substrate (600) the plane of said membrane being substantially parallel to that of said substrate.

**14.** The detection cell as claimed in claim 13, comprising, for each blade, a first connection terminal (601) in electrical contact with a first edge of the blade arranged on the substrate and a second connection terminal (602) in electrical contact with a second edge of the blade arranged on the substrate and opposite the first edge, the group of first connection terminals on the one hand and second connection terminals on the other hand being connected in the case of a plurality of blades.

**15.** The detection cell as claimed in any one of claims 1 to 4, in which the polar crystal forms at least one thin layer (810) surrounded by at least one first and one second barrier layers (811, 812) of semi-conductor dielectric material with a high energy gap so as to form with the polar crystal layer at least one quantum well.

**16.** The detection cell as claimed in claim 15, in which the coupling means (30) comprise a group of optical nano-antennas (834) and a mirror (836) so as to form an optical resonance cavity inside of which said quantum well(s) are located.

**17.** The detection cell as claimed in claim 15, in which the means of coupling (30) in addition comprise a spacer to adapt the width of said optical resonance cavity.

**18.** The detection cell as claimed in any one of claims 15 to 17, comprising at least one first and one second connection terminals in electrical contact with two opposite edges of the thin layer of polar crystal.

**19.** A terahertz detector comprising one or a plurality of detection cells as claimed in any one of the preceding claims and an electrical reading circuit (20) suitable for measuring the impedance variation of the crystal between said connection terminals of each of the detection cells.

**20.** A method for detecting an incident radiation (2) of terahertz frequency included in the Reststrahlen band of a semi-conductor polar crystal (10) comprising the steps of:

- resonant coupling of the incident terahertz frequency radiation (2) and of an interface phonon polariton at an interface of the polar crystal (10) and a dielectric material (11);
- measurement of the impedance variation of the crystal between two opposite ends of said interface, resulting from the absorption by the free carriers of the crystal of the interface phonon polaritons thus excited.

FIG.1

FIG.3A

FIG.2A

FIG.2B

FIG.3B

Coupe BB'

FIG.3C

Coupe AA'

FIG.3D

FIG.4A

## FIG.4B

## FIG.5

FIG.6

FIG.7A

FIG.7B

FIG.8

FIG.9A

FIG.9B

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20080315098 A

**Littérature non-brevet citée dans la description**

- **F. SIZOV ; A. ROGALSKI.** *THz detectors', Progress in Quantum Electronics,* 2010, vol. 34 (5), 278-347
- **F. SIZOV.** *THz radiation sensors', Opto-electronics Review,* vol. 18 (1), 10-36
- **J.L. COUTAZ.** *Optoélectronique THz, EDP Science,* 2008
- **M. BORN ; K. HUANG.** dynamical theory of crystal lattices. Oxford University Press, 1954, 12, , 23
- **L.NOVOTNY et al.** Antennas for light. *nature photonics,* 05 Février 2011
- **L. LI.** Rigourous Coupled Wave Analysis. *Journal of Optical Society of America A,* 1997, vol. 14 (10), 2758
- **P . BOUCHON.** Rigourous Maxwell with Constitutive B-spline approximation. *Journal of Optical Society of America A,* 2010, vol. 27 (4), 696
- **V. L. RIDEOUT.** *Solid-State Electronics,* 1975, vol. 18 (6), 541-550